# EUROPEAN PATENT APPLICATION

(11) **EP 1 727 220 A2**
(43) Date of publication of application: **29.11.2006**
(21) Application number: 06120414.5
(22) Date of filing: 06.09.2000
(51) Int. Cl.: H01L 51/30, H01B 1/12

(54) **Conductive structure based on poly-3,4-alkenedioxythiophene (PEDOT) and polystyrenesulfonic acid (PSS)**

(30) Priority: 10.09.1999 EP 99202950; 04.11.1999 EP 99203636
(62) Divisional of application: 00962444.6
(71) Applicant: Koninklijke Philips Electronics N.V., 5621 BA Eindhoven (NL)
(72) Inventor: Touwslager, Fredericus, J., 5600 AE Eindhoven (NL); De Leeuw, Dagobert, M., 5600 AE Eindhoven (NL); Gelinck, Gerwin, 5600 AE Eindhoven (NL); Willard, Nicolaas, P., 5600 AE Eindhoven (NL)
(74) Representative: Nollen, Maarten Dirk-Johan

(57) **Abstract**

An electronic component has an electrically conductive relief structure (3), which contains a salt of a poly-3,4-alkylenedioxythiophene. This salt provides the structure with a stable conductivity. The salt is a polyacid salt by preference. In the method of manufacturing a relief structure on an electrically insulating substrate the polyacid salt of poly-3,4-alkylenedioxythiophene is used. Relief structures (3) comprising tracks (311-314, 321-324) and channels (141) with track widths (tW) and channel lengths (cL) of less than 10 µm can be achieved. The tracks (311-314; 321-324) are used as electrodes (31;32), the channels (141) are used as semiconductor channels in electronic components, especially in field-effect transistors (11) and light-emitting diodes.

## Description

The invention relates to an electronic component comprising an electrically conductive relief structure on a surface of a substrate, which structure comprises a salt of a poly(3,4-substituted thiophene) as the electrically conductive material.

The invention further relates to a method of manufacturing a relief structure on a substrate.

Such a component and such a method are known from US-A- 5,561,030. The relief structure of the component consists of a number of tracks and is placed on a planar substrate. The salts of poly(substituted thiophenes) known for their use as track materials are salts of poly-3-alkylthiophenes, of poly-3-alkoxythiophenes, and of poly-3,4-dialkoxythiophenes. In the known method, the tracks of the relief structure are used as interconnects and as resistors, and a poly (substituted thiophene) is applied as a layer on a substrate. After irradiation of the layer, the non-irradiated areas of the applied layer are removed by washing, leaving tracks behind which form a relief structure. The salt of the poly(substituted thiophene) is formed by oxidation with an iron salt or a gold salt after the washing step, thereby making the relief structure electrically conductive.

The known component has, disadvantages, however: a first disadvantage being that the conductivity of the tracks in the relief structure deteriorates within a day, unless a gold salt is used as the oxidant. This oxidant is expensive. So, either the component is not stable enough for commercial use, or the cost of its manufacture is high. A second disadvantage is that the tracks are as wide as 1 mm, except if the complicated technique of laser lithography is used. The track length and the distance between tracks is not mentioned, but will be of the same order of magnitude. A component with such dimensions is too large for use in identification tags. Their manufacture is too expensive as well, as the production cost of a component is inversely related to the number of components in a single production batch.

It is an object of the present invention, inter alia, to provide a component of the kind described in the opening paragraph which has a stable conductivity. It is a further object to provide a method of the kind mentioned in the opening paragraph which allows the manufacture of narrow tracks with a stable conductivity at low cost.

The object to provide an electronic component is achieved by a component as specified in the opening paragraph, characterized in that:
- the relief structure contains a polyacid salt of a poly-3,4-alkylenedioxythiophene, in which the alkylene group is chosen from the group consisting of a methylene, an 1,2-ethylene, a 1,3-propylene and a 1,2 cyclohexene group, which groups are optionally provided with a substitution.
- the relief structure comprises at least one electrode.
   The envisaged stable conductivity of the component is achieved through the choice of a specific electrically conductive salts of a specific group of poly(3,4-substituted thiophenes), which group of polythiophenes is hereinafter also called PEDOTs. The PEDOTs are assumed to have a relatively high conductivity ― conductivities higher than 100 S/cm have been observed ― which is considered to be related to the oxygen substitutions at the 3,4-positions. The oxygen substitutions appear to reduce the bandgap in the conducting polymer. Further, the oxygen substitutions do not interrupt the conjugation of the polymeric chain, as the oxygen substitutions have bonding molecular orbitals which are oriented planar to the conjugation of the polymeric chain. The polyacids are assumed to stabilize the conductivity. It appears that the polyacids are less vulnerable to attack by contaminating alkaline molecules than other organic and inorganic acids. The polyacids have a polymeric structure, that appears to hamper diffusion of both the contaminating alkaline molecules and the polyacids themselves.
   Examples of polyacids include poly(styrene sulphonic acid), polyacrylic acid, poly methacrylic acid, poly(vinyl sulphonic acid), poly(vinyl sulphuric acid), poly(vinyl boric acid), poly(styrene boric acid), poly(vinyl phosphoric acid), poly(styrene phosphoric acid), poly(C₁-C₁₂-alkyl sulphonic acid substituted ethylenedioxythiophene), poly(C₁-C₁₂₋alkoxy sulphonic acid substituted ethylenedioxythiophene), .... The polyacid can further be a copolymer of a conductive polymer and a polyacid, wherein the chain comprises blocks of conductive units, for example of a PEDOT, and blocks of acid units.
   Examples of substitutions optionally present at the alkylene groups are C₁-C₁₂₋alkyl groups, C₁-C₁₂-alkoxygroups, fenylgroups, acid groups, such as sulphonic acid, carboxylic acid, boric acid and sulphuric acid, acid substituted C₁-C₁₂-alkyl- and C₁-C₁₂₋alkoxygroups. The substitutions can be used for several objects, such as to influence the solubility of the PEDOT in different solvents, and to provide a structure giving a higher order in the relief structure.
   The structure containing a polyacid PEDOT salt may comprise interconnects and resistors in addition to one or more electrodes. The electrodes may, for example, be part of a diode, a light-emitting diode, a bipolar transistor or a field-effect transistor. A clear advantage of a component with an electrically conductive relief structure comprising a polyacid salt of a PEDOT is the excellent stability of the relief structure and of the material when the structure is brought into contact with, for example, organic and aqueous solvents, polymeric melts or deposited vapors. Relief structures containing a PEDOT salt are less vulnerable to dissolution and to deterioration of their conductivity in alkaline solutions.
   A layer on a substrate surface which comprises a pattern of an electrically conductive PEDOT is known from US-A 5,447,824. This layer comprises conductive areas and less conductive areas. However, leakage currents taking place through the less conductive areas hamper the use of the conductive areas as electrodes.
   The component with an electrically conductive relief structure of a salt of a PEDOT may be realized by, for example, printing techniques such as microcontactprinting, inkjetprinting and silkscreenprinting. Lithographic techniques may alternatively be used, especially for the manufacture of tracks with relatively small track widths and relatively small distances between tracks.
   In an embodiment of the component of the invention, the optionally present substitution contains a sulphonic acid. The acid can also be present as its acid anion. The extent to which the acid is present as its acid anion, presumably depends on the acidity of the solution, from which the relief structure is formed. The advantage of such a substitution is that the PEDOT itself is water-soluble before crosslinking. In effect, the substitution gives the PEDOT an acid character, such that the PEDOT is to be considered as a polyacid itself. Clearly, an additional polyacid is not substantially needed in this embodiment. An additional advantage is that the amount of PEDOT per cubic centimeter that is present in the relief structure of the component of the invention, increases. This results in a better conductivity.
   In a further embodiment of the component of the invention, the relief structure comprises neighboring tracks which lie at a distance of less than 10 µm from one another. Such relief structures are suitable for use in integrated circuits. In this application neighboring tracks are in use as parts of the source and the drain electrode of a MOS-type field-effect transistor. The distance between neighboring tracks will be filled with semiconductor material and will function as a channel. Hence, the distance between neighboring tracks is equal to the channel length cL. This has at least two important implications. First, the switching speed of the transistor is dependent on the channel length. According to the theory of field-effect transistors, this dependence is quadratic. With a channel length of less than 10 µm, it is possible to obtain bit rates of 1 kbit per second. An integrated circuit with such a bit rate is suited for used in data storage and transponders. Besides, as is known from Brown et al., Synthetic Metals 88(1997), 37-55, a small channel length also leads to a high on-off ratio in the transistor, which is a measure for the quality of the transistor. Second, in order to have an integrated circuit, there is not only the need of a small channel length, but also the need for 'gain'. With 'gain' is meant, that the output signal of a transistor or sets of coupled transistors such as NAND-, NOR-, AND-, OR-building blocks, has a voltage, which is as least as high as the voltage of the input signal. It has been found that with channel lengths of less than 10 µm the gain is larger than 1.
   In a preferred embodiment of the component of the invention, the neighboring tracks are able to function as a pair of a source and a drain electrode. At least one of the tracks is furcate, having more than one prong, while the electrodes are interdigitated. These electrodes are positioned so as to enlarge the area of mutual exposure. This embodiment enlarges the source-drain current at a chosen drain voltage, and thereby the on/off ratio.
   In another embodiment of the electronic component of the invention, the component comprises a second relief structure of an electrically conductive material, separated from said ― first - relief structure at least by an insulating layer. The second relief structure prevents leakage currents between tracks in use as interconnects and between tracks in use as electrodes in different transistors, diodes and capacitors.
   In a preferred embodiment, the second relief structure also comprises a salt of a PEDOT.
   In a further embodiment, the component of the invention comprises a field effect transistor. Such a transistor contains a source and a drain electrode, which are interconnected through a channel comprising a semiconducting material. It further comprises a gate electrode, which is separated from the source and the drain electrode by at least an insulating layer. In this embodiment one, relief structure of the component contains the source and the drain electrode. Preferably, these electrodes interdigitate in order to enlarge the channel width. Another relief structure contains the gate electrode. At least one of said relief structures is the relief structure comprising a salt of a PEDOT. The other, second electrically conductive relief structure comprises a salt of a PEDOT, a polyaniline, silicon or a metal such as gold. As is known in the art of transistor manufacture, different designs are possible, such as a 'top-gate'-design and a 'bottom-gate'-design.
   In another embodiment of the component of the invention, the salt of the PEDOT is a polyacid salt. Poly (styrene sulphonic acid) is a preferred polyacid here.
   In a further embodiment, not only the first relief structure, but the complete component substantially consists of polymeric material. Such an "all-polymeric" device has favorable properties, such as a high mechanical flexibility and a low weight. Besides, the component is cheap, and hazardous substances may easily be avoided during its manufacture.
   Organic materials for the semiconductor layer are known from WO-A 99/10939. Examples include polypyrroles, polyphenylenes, polythiophenes, polyphenylene-vinylenes, polythienylene-vinylenes, poly(di)acetylenes, polyfuranes, polyfuranylene-vinylenes, polyanilines. Alternatively, substituted derivatives of these polymers are applied. Examples of substituents are alkyl and alkoxygroups and ring-shaped groups, such as alkylenedioxygroups. By preference, the substituent groups have a carbon chain of 1 to 10 carbon atoms. As is known to those skilled in the art, such materials may be rendered semiconducting by doping with, for example, an oxidizing agent, a reducing agent and/or an acid. A preferred choice is polythienylene-vinylene. Oligomers such as pentacene may also be used as organic semiconductor material
   Organic materials for the insulating layer are known from US-A- 5,347,144. Examples include polyvinylphenol, polyvinyl alcohol and cyanoethylpullane. Preferably an insulating material with a dielectric constant of at least six is used, such as polyvinylphenol, which can be rendered insoluble by cross-linking with a cross-linking agent such as hexamethoxymethylenemelamine and heating.
   Substrate materials are, for example, polymers such as polystyrene, polyimide, polyamide and polyester, or glass, ceramics or silica.
   The object relating to the method is achieved in that the method of manufacturing a relief structure on a substrate comprises the steps of
- forming a radiation-sensitive composition which contains a photochemical initiator, a salt of an anion of a polyacid, and a poly-3,4-alkylenedioxythiophene, in which the alkylene group is chosen from the group consisting of an methylene group, an 1,2-ethylene group, a 1,3-propylene group and a 1,2-cyclohexylene group, which groups are optionally substituted;
- providing said radiation-sensitive composition on the substrate so as to form a layer;
- irradiating said layer in accordance with a desired pattern, thereby obtaining irradiated areas and non-irradiated areas; and
- developing said layer so as to form the electrically conductive relief structure in the desired pattern.

The object relating to the method contains three elements: the manufacture of tracks with stable conductivity, the manufacture of components with narrow tracks, and low-cost manufacture. The stable conductivity is realized in that the composition used in the method according to the invention comprises a salt of a PEDOT. Such a composition is commercially available, but it was not known to be applicable to the manufacture of electrically conductive relief structures. US-A- 5,300,575 teaches the use of this composition to provide an anti-static layer only.

The narrow tracks can be obtained by the use of a salt of a PEDOT containing a polyacid anion as a counterion, hereinafter also referred to as a polyacid salt. This polyacid salt substantially enhances the processability of the PEDOT. As a polyacid is soluble in polar solvents such as water, the polyacid salt of the PEDOT is also more or less soluble in water or at least miscible with water. Through UV-irradiation of a layer of a polyacid salt of PEDOT in a desired pattern and a subsequent re-dissolving of the salt, relief structures with track widths and channel lengths of 10 µm can be obtained. In the art of plastic electronics, such track may be called narrow.

The low cost manufacture is realized in that it is not necessary to use resist layers, and in that water can be used as a solvent. The layer is preferably washed with water in the developing step.

In the method of the invention, the radiation-sensitive layer can be applied on a substrate by spincoating, webcoating or electrical deposition of a solution or dispersion and a subsequent removal of the solvent or dispersion agent. The irradiation used may be UV-irradiation with a photomask, or laser light, electron, X-ray or ion-beams. Irradiation influences the initiator present.

Initiators such as azides, diazides and diazo compounds are assumed to initiate cross-linking between polymeric molecules in the radiation sensitive layers. In the initiating process, the initiator molecules do react away. With such initiators, the non-irradiated areas are not cross-linked and will be washed away. Eventually present initiators in the relief structure, hence after irradiating has taken place, can be removed by baking the relief structure.

In a preferred embodiment, the initiator is the diazide 4,4'-diazidodiebenzalactone-2,2'-disulphonic acid disodium salt. This compound initiates the cross-linking upon irradiation of a wavelength of 360-370 nm. This is advantageous, as such a wavelength is provided by a mercury lamp. Further, with initiators initiating the cross-linking upon irradiation of a shorter wavelength, such as less than 300 nm, the irradiation will probably influence the conductivity of the PEDOTs. With initiators initiating the cross-linking upon irradiation of a larger wavelength, such as more than 400 nm, the initiator initiates due to normal light and the process should be executed in a dark room. Initiators, such as perchlorate, chromate and iron(III) tris(toluenesulphonate) are assumed to be brought into an excited state by irradiation, after which they act as strong oxidizers towards the conjugated chain of poly-3,4-ethylenedioxythiophenes in the radiation-sensitive layer and demolish the conjugation. A specific example is disodiumchromate. By heating to 150 °C after irradiation of the chromate-doped layer of a poly(styrene sulphonic acid) salt of PEDOT, the electrically conductive PEDOT can be made insoluble in water. The irradiated parts can be subsequently dissolved in water or some other polar solvent such as an alcohol, so as to form the relief structure. The removal of the areas during the developing step can be enhanced in a spray process.

In a preferred embodiment of the method of the invention, the composition comprising the polyacid salt of the PEDOT is filtrated before application on the substrate. Preferably, a filter having pores with a diameter of 5 µm or less is used in the filtration. The filtration prevents the eventual presence of particles larger than the widths of the tracks formed.

In a further embodiment of the method of the invention, the electrical conductivity of the relief structure is enhanced by an additional step performed after washing, in which step the relief structure is doped with an organic compound containing a first functional group selected from dihydroxy, polyhydroxy, carboxyl, lactam and amide, sulphon, sulphoxy, phosphate, and mea. The enhancement of the electrical conductivity is unexpectedly large, while the relief structure is not damaged or demolished. The inventors tentatively presume, without being bound by it, that the doping with said organic compound provides a change in the microstructure of at least part of the relief structure. Besides, the inventors have the impression that the doping after washing is very efficient: first, the solvent of the composition comprising a PEDOT salt has been removed at least for a major part at that moment. Molecules of the added organic compounds will interact with the polymeric molecules mainly. Second, the surface area of the relief structure is larger than the surface area of the layer. The distribution of the organic compound may be assumed to be reasonably good.

Suitable organic compounds containing dihydroxy or polyhydroxy and/or carboxyl groups or amide groups correspond to the general formula (HO)ₙ-R-(COX)ₘ, wherein:
- n and m denote an integer from 1 to 20, preferably from 2 to 8, independently of one another, and
- R denotes a linear, branched or cyclic alkylene radical having 2 to 20 carbon atoms, or an optionally substituted arylene radical having 6 to 14 carbon atoms, or a heterocyclic radical having 4 to 10 carbon atoms, or a sugar radical or sugar alcohol radical, and
- x denotes ―OH or ―NYZ, wherein Y, Z independently of one another represent hydrogen or alkyl, preferably hydrogen or C₁ to C₁₂-alkyl.

Examples of preferred organic compounds are sugar, sugar derivatives and sugar alcohols, such as sucrose, glucose, fructose, lactose, sorbitol, mannitol and lactitol; alcohols such as ethylene glycol, glycerol, di- or triethylene glycol; carboxylic acids, such as furancarboxylic acid. A particular by preferred organic compound is sorbitol.

The invention will be explained in more detail blow with reference to embodiments and the accompanying drawings, given by way of example only, wherein:

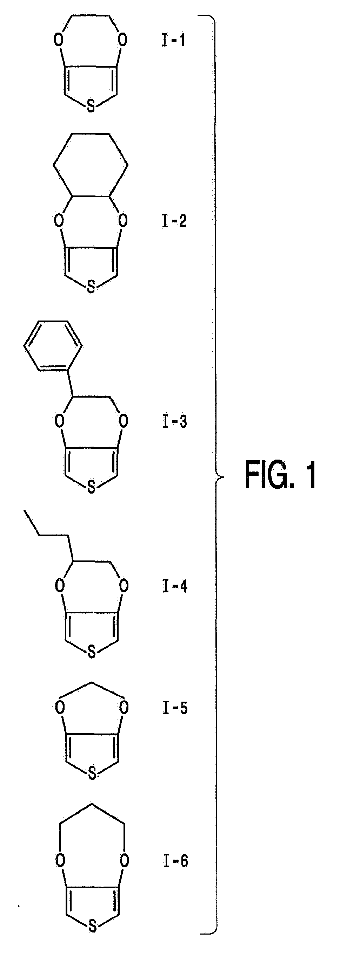

Fig. 1 shows the structural formulae of the repetitive units of a poly-3,4-alkylenedioxythiophene, with alkylene groups ethylene (I-1), 1,2-cyclohexylene (1-2), phenylethylene (1-3), propylethylene (1-4), methylene (1-5) and 1,3-propylene (1-6);
Fig. 2 shows the structural formula of a polyanion salt of poly-3,4-ethylenedioxythiophene, with n,m>10;
Fig. 3 diagrammatically shows a plan view of a field-effect transistor containing conductive relief structures of the component according to the invention;
Fig. 4 diagrammatically shows a cross-sectional view of a field-effect transistor with two relief patterned conductive layers, in which the first layer comprises the source and the drain electrode and in which the second layer contains the gate electrode;
Fig. 5 diagrammatically shows a plan view of field-effect transistor with interdigitated source and a drain electrodes. For reasons of clarity the substrate, the insulating layer and the semiconductor layer are omitted from the drawing;
Fig. 6 diagrammatically shows a cross-sectional view of a light emitting diode.

### Embodiment 1

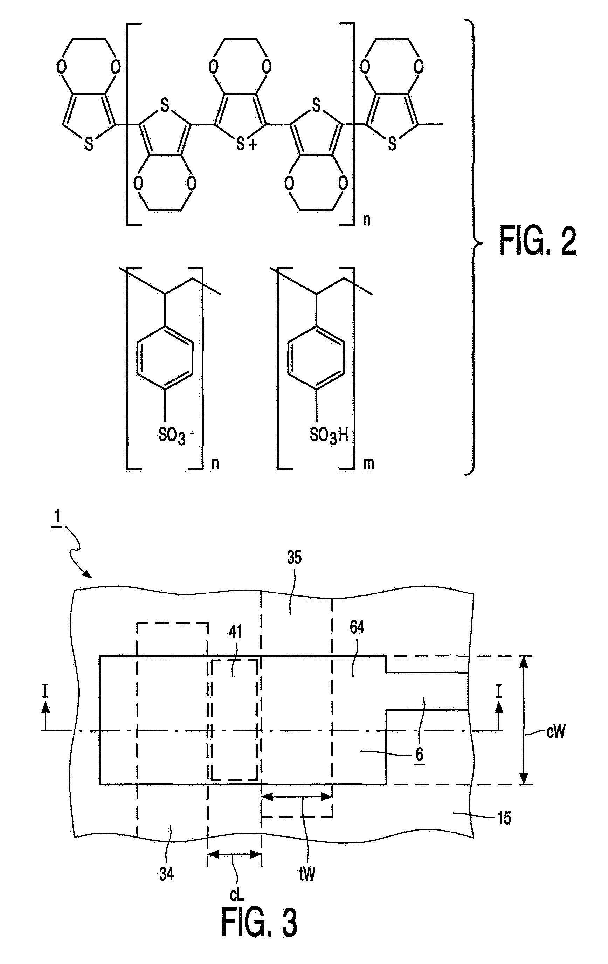

The structural formula of the poly(styrene sulphonic acid) salt of poly-3,4-ethylenedioxythiophene is shown in figure 2. A composition of this salt in water is commercially available from Bayer. The concentration of PEDOT in this composition is 0.5% by weight and that of poly(styrene sulphonic acid) is 0.8% by weight. To the composition, apparently a colloidal solution, about 0.25% by weight of the initiator 4,4'-diazidodibenzalacetone-2,2'-disulphonic acid disodium salt and 0.005% by weight dodecylbenzenesulphonic acid sodium salt are added. After filtration through a 5 µm filter, the composition was spin coated onto an insulating and planarized substrate. The layer obtained was dried at 30 °C for 5 minutes. The dried layer was exposed through a mask to patterned radiation with UV light (λ=365 nm) by means of a Hg lamp. The layer was washed by spraying with water. In this washing step, the nonirradiated areas of the layer were dissolved. After drying at 200 °C, the average layer thickness of the remaining areas was 80 nm. These areas had an electric conductivity of 1 S/cm. Each continuous undissolved area functions as a track. Track widths of 1, 3, 5, 8, 10 and 20 µm and distances between tracks of 5, 8, 10 and 20 µm were obtained in various experiments.

### Embodiment 2

The same procedure to obtain relief structures was followed as in Embodiment 1. However, after the washing and drying at room temperature, in which a relief structure comprising PEDOT was obtained on the substrate, an solution of sorbitol (about 4-6% by weight) was spin-coated onto the relief structure. The resulting structure was heated to 200 °C. The remaining areas had a conductivity of 170 S/cm. Each continuous undissolved area functions as a track.

### Embodiment 3

A poly(styrene sulphonic acid) salt of poly-3,4-ethylenedioxythiophene in water is commercially obtainable from Bayer. The concentration of PEDOT in this composition is 0.5% by weight and that of poly(styrene sulphonic acid) is 0.8% by weight. The composition, apparently a colloidal solution, was adjusted to a pH = 7. Then 0.03% by weight of disodium chromate, Na₂Cr₂O₇ was added. After filtration through a 5 µm filter, the composition was spin coated onto an insulating and planarized substrate. The insulating substrate in this case was a stack of a polyimide substrate, a thin patterned layer of gold and an insulating layer of polyvinylphenol comprising a cross-linking agent. The layer obtained was dried at 100 °C for 5 minutes. The dried layer was exposed through a mask to patterned radiation with UV light (λ = 365 nm) by means of a Hg lamp. The layer was developed in water. Then a solution of a precursor of polythienylene-vinylene was spin-coated onto the substrate and heated in order to form polythienylene-vinylene. Subsequently a layer of the commercially available Kapton comprising a polyimide was deposited. This layer protects the electronic component thus formed and comprising a relief structure of a PEDOT against irradiation with a wavelength λ < 500 nm.

### Embodiment 4

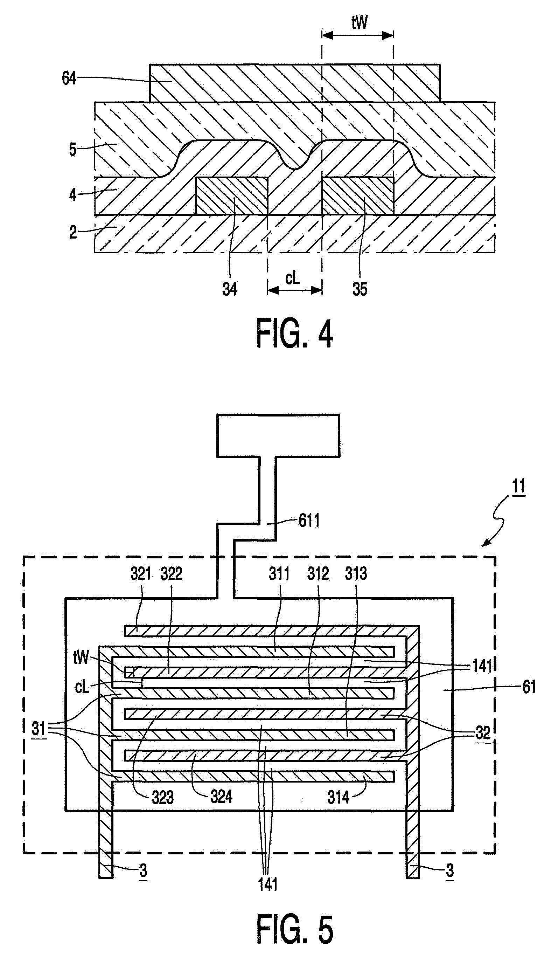

Fig. 3 diagrammatically shows a plan view of a field effect transistor 1 comprising conductive relief structures of the component according to the invention. Fig. 4 diagrammatically shows the field-effect transistor 1 in a cross-sectional view (not true to scale) taken on the line I-I in Fig.3. The field effect transistor 1 comprises an electrically insulating substrate 2 of polyimide covered with a planarized layer of polyvinylphenol cross-linked with hexamethoxymethylenemelamine, on which is provided a first electrically conductive relief structure 3 comprising poly(3,4-ethylenedioxythiophene), poly(styrene sulphonic acid) and sorbitol. This relief structure 3 comprises a source electrode 34 and a drain electrode 35 with a track width tW of 5 µm. On the first relief structure a semiconductor layer 4 comprising poly(thienylene-vinylene) is provided, which layer 4 comprises a channel 41 with a channel length cL of 15 µm and a channel width cW of 50 µm. Covering the layer 4 and thus the channel 41 is an electrically insulating layer 5 comprising the commercially available HPR504, which is deposited as a solution in ethyl lactate. It electrically insulates the gate electrode 64 from the channel 41, said gate electrode 64 being accommodated in the second electrically conductive relief structure 6 comprising PEDOT. The transistor 1 is of the "top gate" type.

### Embodiment 5

Fig. 5 diagrammatically shows a plan view of field-effect transistor 11, which comprises a first relief structure 3 comprising PEDOT and accommodating an interdigitated pair of a source electrode 31 and a drain electrode 32. The substrate, the insulating layer and the semiconductor layer are omitted from the drawing for reasons of clarity. The source electrode 31 is fork-shaped and comprises parallel tracks 311, 312, 313 and 314. The drain electrode 32 is fork-shaped and comprises tracks 321, 322, 323 and 324. In this example, each of the electrodes 31, 32 comprises four tracks with a track width tW of 2 µm; however, this is neither necessary nor meant to be limiting. The source 31 and drain electrode 32 are separated by a channel 141 with a channel length cL of 5 µm. The transistor 11 further comprises a second relief structure comprising gold and accommodating electrical conductors 611 and a gate electrode 61. The transistor 11 is of a "bottom gate" type. In this type of transistor the second relief structure lies on the substrate, on which the dielectric layer, the first relief structure, and the semiconductor layer comprising pentacene are arranged in that order.

### Embodiment 6

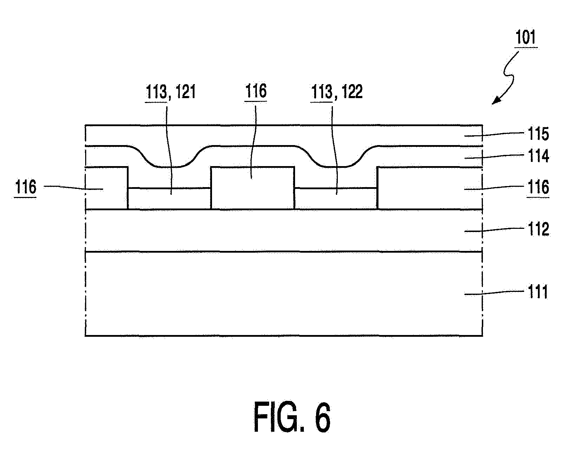

Fig. 6 diagrammatically shows a cross-sectional view of a light emitting diode 101. This electronic component comprises a substrate 111, a first electrode layer 112, a first relief structure 113, a semiconductor layer 114 and a second electrode layer 115. Typically, the substrate 111 is made of glass, the first electrode layer 112 comprises ITO, and the second electrode layer 115 comprises Al. The first relief structure 113 comprises a electrically conductive PEDOT and the semiconductor layer 114 comprises polyphenylene-vinylene. The patterns 121, 122 have a size of 100 µm in length and in width. The relief structure 113 and the semiconductor layer 114 each have a thickness which is of the order of 100 nm. The light emitting diode may be manufactured by sputtering ITO on the substrate 111. A solution of polyvinylphenol and the cross linking agent hexamethoxymethylmelamine (HMMM) in propyleneglycolmethyletheracetate is spin coated on, to the ITO so as to form a layer of 200 nm. The layer is irradiated in a desired pattern and washed, so as to form a patterned layer 116 and to remove the insulator in the areas where the patterns 121, 122 are to be formed. A aqueous colloidal solution of PEDOT, poly(styrene sulfonic acid) and a photoinitiator is spin coated on to the substrate so as to form a layer. The layer is subsequently irradiated in the desired pattern and developed in water so as to form the relief structure 113. Then the semiconductor 114 is spin coated. Finally, the second electrode layer 115 is deposited.

The disclosure of this application also includes the following numbered clauses:
An electronic component comprising an electrically conductive relief structure (3) on a surface of an electrically insulating substrate (2), which structure comprises a salt of a poly(3,4-substituted thiophene) as electrically conductive material,
characterized in that:
- the relief structure (3) contains a polyacid salt of a poly-3,4-alkylenedioxythiophene, in which the alkylenegroup is chosen from the group consisting of a methylene group, an 1,2-ethylene group, a 1,3-propylene group and a 1,2-cyclohexylene group, which groups are optionally substituted, and
- the relief structure (3) comprises at least one electrode (32).
   An electronic component as claimed in claim 1, the optionally present substitution contains a sulphonic acid.
   An electronic component as claimed in claim 1, characterized in that the relief structure (3) comprises neighboring tracks (341, 351) which lie at a distance of less than 10 µm from one another.
   An electronic component as claimed in claim 3, characterized in that neighboring tracks (341, 351) form a pair of a source and a drain electrode (34, 35), at least one of which is fork-shaped, the source and the drain electrode being interdigitated.
   An electronic component as claimed in claim 1, characterized in that the component comprises a second electrically conductive relief structure (6) separated from said relief structure (3) at least by an insulating layer (5).
   An electronic component as claimed in claim 5, characterized in that the second relief structure (6) contains a salt of a poly-3,4-alkylenedioxythiophene, in which the alkylene group is chosen from a set consisting of an optionally C₁ to C₁₂- alkyl- or phenylsubstituted methylene group, an optionally C₁ to C₁₂-alkyl- or phenylsubstituted 1,2-ethylene group, a 1,3-propylene group, and a 1,2-cyclohexylene group.
   An electronic component as claimed in claim 5, characterized in that the component comprises a field effect transistor (1).
   An electronic component as claimed in claim 1, characterized in that the component substantially consists of organic polymeric material.
   A method of manufacturing a relief structure (3) on a substrate (2), comprising the steps of
- forming a radiation-sensitive composition which contains a photochemical initiator and a salt of an anion of a polyacid and a poly-3,4-alkylenedioxythiophene, in which the alkylene group is chosen from a set consisting of an optionally C₁ to C₁₂- alkyl- or phenyl-substituted methylene group, an optionally C₁ to C₁₂-alkyl- or phenyl-substituted 1,2-ethylene group, a 1,3-propylene group and, a 1,2-cyclohexylene group;
- providing said radiation-sensitive composition on the substrate so as to form a layer;
- irradiating said layer in accordance with to a desired pattern, thereby obtaining irradiated areas and non-irradiated areas; and
- developing said layer so as to form the electrically conductive relief structure in the desired pattern.

A method as claimed in claim 9, characterized in that the non-irradiated areas are removed in the developing step.

A method as claimed in claim 9 or 10, characterized in that the method comprises, after the developing step, the additional step of doping said relief structure with an organic compound containing a first functional group selected from polyhydroxy, dihydroxy, carboxyl, lactam and amide, sulphon, sulphoxy, phosphate, and mea.

## Claims

1. An electronic component comprising an electrically conductive relief structure (3) on a surface of an electrically insulating substrate (2), which relief structure (3) comprises a polyacid salt of a poly-3,4-alkylenedioxythiophene as electrically conductive material, in which the alkylene group is chosen from the group consisting of a 1,2-methylene group, an 1,2-ethylene group, a 1,3-propylene group and a 1,2-cyclohexylene group, which group could contain with substituents,
**characterized in that**:
- the relief structure comprises at least one electrode (32), which has a width of at most 100 µm, and
- the relief structure is obtainable by a method comprising the steps of:
- providing a radiation-sensitive composition of a photochemical initiator and said polyacid salt on the surface of the substrate so as to form a layer;
- irradiating said layer in accordance with a desired pattern with a wavelength between 300 and 400 nm, thereby obtaining irradiated, cross-linked areas and non-irradiated areas;
- developing the non-irradiated areas, so as to form the relief structure in the desired pattern; and
- doping the thus formed relief structure to enhance its electrical conductivity with an organic compound containing a first functional group selected from polyhydroxy, dihydroxy, carboxyl, lactam and amide, sulphon, sulphoxy, phosphate and mea.

2. An electronic component as claimed in claim 1, wherein the conductivity is enhanced to more than 100 S/cm.

3. An electronic component as claimed in claim 1, wherein the electrode (32) has a width of at most 50 µm.

4. An electronic component as claimed in claim 1, 2 or 3, wherein the relief structure further comprises interconnects.

5. An electronic component as claimed in any of the previous claims, wherein the relief structure comprise tracks that are defined at a mutual distance of at most 20 µm.

6. An electronic component as claimed in any of the previous claims, wherein the electrode is part of a field-effect transistor.

7. An electronic component as claimed in claim 6, wherein the relief structure comprises neighboring tracks which lie at a distance of less than 10 µm from one another and are defined as parts of a source and a drain electrode of the field-effect transistor.

8. An electronic component as claimed in claim 7, wherein the transistor is part of an integrated circuit.

9. An electronic component as claimed in claim 1 or 2, wherein a second relief structure of an electrically conductive material is present that is separated from said ― first ― relief structure at least by an insulating layer.

10. An identification tag comprising the electronic component of any of the previous claims.
